# EUROPÄISCHE PATENTSCHRIFT

(11) **EP 1 200 340 B1**
(45) Veröffentlichungstag und Bekanntmachung des Hinweises auf die Patenterteilung: **08.11.2006**
(21) Anmeldenummer: 00953150.0
(22) Anmeldetag: 03.08.2000
(51) Int. Cl.: C01B 21/14, B01J 45/00

(54) **VERFAHREN ZUR HERSTELLUNG VON HOCHREINEN STABILISIERTEN HYDROXYLAMINLÖSUNGEN**
METHOD FOR PREPARING HIGHLY STABILISED HYDROXYLAMINE SOLUTIONS
PROCEDE POUR PREPARER DES SOLUTIONS D'HYDROXYLAMINE STABILISEES DE GRANDE PURETE

(30) Priorität: 04.08.1999 DE 19936594
(43) Veröffentlichungstag der Anmeldung: 02.05.2002
(73) Patentinhaber: BASF Aktiengesellschaft, 67056 Ludwigshafen (DE)
(72) Erfinder: WATZENBERGER, Otto, 68199 Mannheim (DE); WILFINGER, Hans, Jörg, 67105 Schifferstadt (DE)
(74) Vertreter: Kinzebach, Werner
(86) Internationale Anmeldenummer: PCT/EP2000/007542
(87) Internationale Veröffentlichungsnummer: WO 2001/010777

(56) Entgegenhaltungen:
- US-A- 5 872 295

## Beschreibung

Die Erfindung betrifft ein Verfahren zur Herstellung von hochreinen stabilisierten Hydroxylaminlöungen (HA-Lösungen), wobei eine wässrige Hydroxylaminausgangslösung zur Abtrennung von Anionen mit einem Anionenaustauscher behandelt wird.

Hochreine, konzentrierte, wässrige Hydroxylaminlösungen werden unter anderem in der Elektronikindustrie, beispielsweise zum Vorreinigen von Platinen verwendet. Für die Verwendung in der Elektronikindustrie werden in den dabei eingesetzten Ausgangsmaterialien, wie Lösungen, Substanzen und sonstigen Mitteln, üblicherweise Konzentrationen an verunreinigungen, beispielsweise Anionen, von unter 10 ppm gefordert. Derartig hochreine Ausgangsmaterialien nennt man "Electronic Grade"-Waren. Die zur Zeit im Handel erhältlichen wässrigen Hydroxylaminlösungen enthalten jedoch aus der Herstellung Verunreinigungen im 30 ppm-Bereich, wie beispielsweise Natriumsulfat.

Eine Möglichkeit der Reinigung von wässrigen Hydroxylaminlösungen ist in der US-A-5,872,295 beschrieben. Dabei wird die Hydroxylaminlösung zunächst über wenigstens einen stark sauren Ionenaustauscher, der zuvor mit verdünnter Salzsäure behandelt wurde, und dann über wenigstens einen stark basischen Anionenaustauscher, der mit einer nichtmetallischen Amino- oder Hydroxid-Basenlösung vorbehandelt oder regeneriert wurde, geleitet. Anschließend wird die so gewonnene, einer doppelten Austauschbehandlung unterzogene HA-Lösung mit einem Stabilisator versetzt. Die erhaltene HA-Lösung wird also nachträglich stabilisiert. Abgesehen von dem damit verbundenen Zusatzaufwand ergibt sich daraus das Problem, dass der Stabilisator aus seinem Herstellungsprozess Metallionen, insbesondere Natrium, in relativ großen Mengen - etwa 1 ppm - enthält. Da die E-Grade-Chemikalien primär metallionenfrei sein müssen, verbietet sich eine derartige Nachstabilisierung, da dadurch wieder Natriumionen eingetragen werden.

Aus US-A-5,788,946 ist ein ähnliches Verfahren zum Reinigen von Hydroxylamin bekannt, das zu einer wesentlichen Reduktion in Bezug auf den Gehalt an Kationen und Anionen führt. Bei diesem Verfahren wird eine Lösung von Hydroxylamin durch wenigstens ein stark saures Ionenaustauscherbett geleitet, das zuvor mit einer verdünnten Salzsäure behandelt wurde, und anschließend durch wenigstens ein Bett aus einem stark basischen Anionenaustauscherharz. Die bei diesem bekannten Verfahren erhaltene wässrige Hydroxylaminlösung ist nicht stabilisiert. Würde die Hydroxylaminlösung nachträglich stabilisiert, ergäben sich ebenfalls die bereits vorstehend erwähnten Probleme.

Aus der US-A-4,147,623 ist ein Verfahren zum Abtrennen von Hydroxylamin aus einer wässrigen Hydroxylammoniumsalzkösung bekannt; die Lösung enthält Kationensalze, deren jeweilige korrespondierende freie Basen Dissoziationskonstanten von > 10⁻⁷ aufweisen. Zu derartigen Salzen gehört auch das bereits erwähnte Natriumsulfat. Gemäß diesem bekannten Verfahren wird die eingesetzte Ausgangslösung zunächst auf einen pH-Wert von 6 bis 11 gebracht, anschließend durch ein Bett eines stark ionischen Austauscherharzes geleitet, bei dem es sich um ein Kationenaustauscherharz oder ein Anionenaustauscherharz handeln kann. Unter diesen Bedingungen werden die Hydroxylaminionen größtenteils in elektrisch neutrale Hydroxylamin-Moleküle transformiert, wohingegen die anderen in der Lösung vorhandenen Salze im Wesentlichen nicht beeinflusst werden. Wenn die Lösung also über den Kationen- bzw. Anionenaustauscher geleitet wird, wird das elektrisch nicht geladene Hydroxylamin im Austauscherharz zurückgehalten, während die Salze als erste im Eluat die Säule verlassen. Auch die gemäß diesem Stand der Technik erhaltene Lösung ist nicht stabilisiert und müsste, wie bereits oben erwähnt, nachstabilisiert werden. Auch hier ergäben sich also wieder die vorstehend bereits diskutierten Probleme.

Die PCT/EP99/00993 beschreibt die Herstellung im wesentlichen metallionenfreier Hydroxylaminlösungen durch Behandlung mit einem sauren Kationenaustauscher.

Eine andere Möglichkeit der Reinigung besteht in der destillativen Aufarbeitung von Hydroxylaminlösungen gemäß US-A-5,472,679. Allerdings muss bei der Destillation darauf geachtet werden, dass eine Temperatur von 65 °C nicht überschritten wird, weil die Onset-Temperatur, d. h. diejenige Temperatur, bei der eine erkennbare Zersetzung beginnt, bei einer 50 gew.-%igen Hydroxylaminlösung bei ca. 70 °C liegt. Alternative Destillationsmöglichkeiten sind in der WO 97/22551 und WO 98/57886 beschrieben, wobei gemäß WO 98/57886 "Electronic-Grade"-Hydroxylamin erhalten wird. Eine Destillation, insbesondere bei niedrigen Temperaturen und Drücken ist mit entsprechendem Aufwand und Zeitbedarf verbunden. Dementsprechend sind auf diese Weise hergestellte salzfreie wässrige Hydroxylaminlösungen in "Electronic Grade"-Reinheit entsprechend teuer und damit in ihrer Anwendung auf wenige Einsatzbereiche beschränkt.

Aufgabe der Erfindung ist es also, ein Verfahren zur Herstellung stabilisierter wässriger hochreiner Hydroxylaminlösungen bereitzustellen, die den Anforderungen an eine "Electronic Grade"-Reinheit genügen. Außerdem soll das Verfahren im Vergleich zum im Stand der Technik üblichen verfahren weniger kostenaufwendig sein. Schließlich soll das Verfahren ohne Gefahr der Zersetzung des Hydroxylamins durchführbar sein.

Diese Aufgabe wird erfindungsgemäß durch ein Verfahren gelöst, bei dem hochreine stabilisierte Hydroxylaminlösungen dadurch hergestellt werden, dass man eine wässrige Anionen enthaltende stabilisierte Hydroxylaminausgangslösung zur Abtrennung der Anionen mit einem Anionenaustauscher, der mit einem Hydroxylamin-Stabilisator beladen ist, behandelt.

Erfindungsgemäß versteht man unter hochreinen HA-Lösungen solche HA-Lösungen, deren Gehalt an Anionen, insbesondere Sulfationen, unterhalb der quantitativen Nachweisgrenze liegt, d. h. zum Beispiel unterhalb von 10 ppm. Bevorzugt sind solche HA-Lösungen, deren Gehalt an Kationen (Metallionen, insbesondere Alkalimetallionen, wie Natriumionen) weniger als 1 ppm, insbesondere weniger als 0,1 ppm, beträgt.

Als Hydroxylaminausgangslöung wird im Allgemeinen eine HA-Lösung verwendet, deren Gehalt an Anionen bis zu 50 ppm, im Allgemeinen 20 bis 40 ppm Anionen, insbesondere Sulfationen, aufweist. Der Gehalt an Kationen beträgt im Allgemeinen bis zu etwa 50 ppm, insbesondere bis zu 30 ppm. Die Hydroxylaminkonzentration derartiger Lösungen liegt im Allgemeinen im Bereich von 1 bis 70 Gew.-%, insbesondere 5 bis 60 Gew.-%. Die Herstellung derartiger HA-Lösungen ist dem Fachmann bekannt und beispielsweise beschrieben in der WO 97/22551 oder US-A-5,472,679.

Als Anionenaustauscher sind schwach basische, vorzugsweise jedoch stark basische Anionenaustauscher brauchbar. Geeignete Anionenaustauscher sind beispielsweise die Amberlite-, Duolite- und Purolite-Harze der Fa. Rohm & Haas, wie Amberlite IRA-400, IRA-402, IRA-904 und bevorzugt IRA-92 und IRA-93, Duolite A-109 sowie Purolite A-600, A-400, A-300, A-850 und A-87, sowie die Lewatit-Harze der BAYER AG, wie Lewatit M 511. Die Basenform des Anionenaustauschers kann mit üblichen Basen, wie Natriumhydroxid oder Kaliumhydroxid, oder Ammoniak erzeugt werden.

Erfindungsgemäß werden Anionenaustauscher,eingesetzt, die mit einem Stabilisator beladen sind. Die Anionenaustauscher kommen in der Hydroxylform mit einem pH im Bereich von 8 bis 14 zur Anwendung. Im Falle eines schwach basischen Anionenaustauschers liegt der pH im Bereich von 8 bis 12, insbesondere 8 bis 11, im Falle eines stark basischen Anionenaustauschers im Bereich von 12 bis 14, insbesondere 13 bis 14. Geeignete Stabilisatoren sind solche, die von einem Anionenaustauscher gebunden werden. Dabei handelt es sich beispielsweise um Thioglykolsäure, Hydroxyanthrachinone, Hydroxychinoline, Hydroxychinaldine, die Salze der Ethylendiamintetraessigsäure oder der N-Hydroxylethylethylendiaminotriessigsäure, Hydroxansäuren, Dipyridyl-verbindungen, Aminochinoline oder Phenantroline.

Bevorzugte Stabilisatoren sind die Verbindungen der Formel

R¹R²N-A-NR³R⁴ (I)

worin
- A: für Alkylen, Alkenylen, Alkinylen, Cycloalkylen, Cycloalkenylen, Arylen, einen 5- oder 6-gliedrigen gesättigten oder ungesättigten Heterocyclus mit einem Stickstoffatom steht, wobei die genannten Reste 1, 2 oder 3 Substituenten aufweisen können, die unabhängig voneinander ausgewählt sind unter Alkyl, Alkoxy oder Hydroxy, oder für 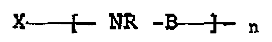
steht, worin
- B und X: für - CH₂CH₂- oder -CH₂CH₂CH₂- stehen,
- n: für 10 - 50 000 steht,
- R: für H, Alkyl, einen durch OB, NH₂, NHCOR⁵ oder COOR substituierten Ethylen- oder Propylenrest, CSSH, CH₂CN oder CH₂PO₃H₂ steht oder eine Brücke zu einem Stickstoffatom einer anderen Polyethylenimin- oder Polypropyleniminkette darstellt, wobei die Brücke durch 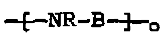 oder 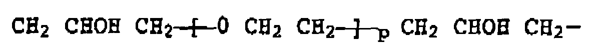 gebildet wird, wobei o und p unabhängig voneinander für 1 - 15 stehen,
- R⁵: für H, C₁-C₁₈-Alkyl oder
CHR⁶COR⁶ steht, wobei R⁶ einen C₁₂-C₁₈-Alkylrest bedeutet,
- R¹, R², R³ und R⁴: unabhängig voneinander für H, CH₂COOH, CH₂PO₃H₂, Alkyl, Acyl, CH₂CH₂OH, CH₂CH₂NH₂ oder 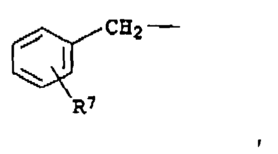 stehen, wobei
- R⁷: für OH, SH, NH₂, CN, COOR, Alkyl oder Alkoxy steht,
oder die Salze davon.

A steht z.B. für o-, m- oder p-Xylylen.

Diese Stabilisatoren sind in der US-A-5,783,161 beschrieben, auf deren Offenbarungsgehalt in vollem umfang Bezug genommen wird.

Besonders bevorzugte Stabilisatoren sind cis- oder trans-1,2-Diamino-C₅-C₆-alkyl-N,N,N',N'-tetraessigsäure, N,N'-Di(2-hydroxybenzyl)ethylendiamin-N,N'-diessigsäure; Diethylentriaminpentaessigsäure; Ethylenbis(oxyethylennitrilo)tetraessigsäure, cis- oder trans-1,4-Diaminocyclo-C₅-C₆-alkyl-N,N,N',N'-tetraessigsäure; Bis-hexamethylentriamin-pentaessigsäure; Hexamethylendiamin-tetraessigsäure; Tris(2-aminoethyl)amin-hexaessigsäure; Iminodiessigsäure oder Polyethylenimin.

Die Beladung des Anionenaustauschers mit dem Stabilisator kann in üblicher Weise erfolgen. Zu diesem Zweck wird der Anionenaustauscher mit einer Lösung des Stabilisators behandelt. Der Stabilisator wird zu diesem Zweck in wasser oder einer wässrigen Hydroxylaminlösung, die im Allgemeinen einen Gehalt von bis zu 70 Gew.-%, insbesondere 10 bis 50 Gew.-% Hydroxylamin aufweist, gelöst. Vorzugsweise verwendet man eine Lösung des Stabilisators in einer Hydroxylaminlösung, die etwa die gleiche Konzentration aufweist wie die anschließend zur Entfernung der Anionen zu behandelnde Hydroxylaminlösung. Die Stabilisatorlösung enthält im Allgemeinen 1 bis 20 Gew.-%, insbesondere 2 bis 8 Gew.-% des Stabilisators.

Zur Beladung wird der Anionenaustauscher mit der Stabilisatorlösung in Kontakt gebracht, beispielsweise durch Behandlung in einem Reaktionsgefäß unter Rühren. Vorzugsweise jedoch gibt man die Stabilisatorlösung über ein Bett des Anionenaustauschers, beispielsweise eine mit dem Anionenaustauscher beschickte Säule.

Die Behandlung der zu reinigenden HA-Lösung mit dem mit Stabilisator beladenen Anionenaustauscher erfolgt in analoger Weise, d. h. der Anionenaustauscher wird mit der zu reinigenden Hydroxylaminlösung beispielsweise durch Behandlung in einem Reaktionsgefäß unter Rühren in Kontakt gebracht oder vorzugsweise über ein Bett des Anionen-austauschers, beispielsweise eine mit dem Anionenaustauscher beschickte Säule, geleitet.

Die Temperatur, bei welcher die Behandlung erfolgt, ist nicht kritisch. Im Hinblick auf die Zersetzlichkeit des Hydroxylamins wird man jedoch höhere Temperaturen vermeiden. Im Allgemeinen arbeitet man bei einer Temperatur im Bereich von 0 °C bis etwa 70 °C, vorzugsweise 20 bis 40 °C.

Das Mengenverhältnis von zu reinigender HA-Lösung und beladenem Anionenaustauscher hängt von der Menge an zu entfernenden Anionen ab. Der Fachmann kann die geeignete Menge auf einfache Weise durch Verfolgung des Reinigungseffektes bestimmen.

Das erfindungsgemäße Verfahren kann kontinuierlich oder diskontinuierlich durchgeführt werden. Bevorzugt ist die kontinuierliche Betriebsweise.

Die erfindungsgemäße Behandlung der Hydroxylaminlösung mit einem mit Stabilisator beladenen, basischen Anionenaustauscher kann mit einer Kationenaustauscher-Behandlung kombiniert werden. Die Behandlung mit dem Kationenaustauscher kann vor oder nach der Behandlung mit dem Anionenaustauscher erfolgen. Dabei kann es sich um einen schwach sauren Kationenaustauscher mit einem pH in der Säureform im Bereich von 2 bis 6, insbesondere 3 bis 6, handeln. Auch Kationenaustauscher mit chelatbildenden Gruppen, wie Iminodiessigsäuregruppen, sind geeignet.

Brauchbare schwach saure Kationenaustauscher sind beispielsweise die Lewatit TP-Typen der Firma Bayer, wie Lewatit TP 207, die Amberlite IRC-Typen, Duolite C 433 etc., Dowex CCR oder MWC u. dgl. Die Kationenaustauscher kommen in der Säureform zur Anwendung. Gegebenenfalls werden sie zu diesem Zweck mit einer Säure, beispielsweise Schwefelsäure behandelt, um das Kation zu entfernen. Danach wird üblicherweise mit hochreinem Wasser, säurefrei gespült.

Die Behandlung der Hydroxylaminlösung kann auch mit einem stark sauren Kationenaustauscher in der Säureform erfolgen, d. h. einem Kationenaustauscher mit einem pH in der Säureform im Bereich von 0 bis 2, insbesondere 0 bis 1. Brauchbare stark saure Kationenaustauscher sind beispielsweise die Harze Amberlite IR-120, IR-122, IRC-50 und Amberjet 1500H der Fa. Rohm & Haas, Dowex 88 von Dow Chemical, Duolite C-200, C-26 und C-280 der Fa. Rohm und Haas sowie Purolite C-100, C-105 und C-150. Die Säureform kann mit üblichen starken Säuren, wie Salzsäure oder Schwefelsäure, erzeugt werden.

Die Behandlung mit dem Kationenaustauscher erfolgt in analoger Weise zu der Behandlung mit dem Anionenaustauscher. Weitere Angaben zu der Behandlung mit dem Kationenaustauscher sind in der DE 198 06 578.7 beschrieben, auf die hiermit Bezug genommen wird.

Durch die Behandlung der HA-Lösung mit dem Stabilisierten Anionenaustauscher wird vermieden, dass der Stabilisator an den Anionenaustauscher gebunden und die gereinigte Hydroxylaminlösung verarmt an Stabilisator vorliegt oder sogar frei von Stabilisator ist. Das mit dem Verfahren des Standes der Technik verbundene 2ersetzungsrisiko ist daher verringert.

Die wässrige Hydroxylaminausgangslösung ist bereits mit dem Stabilisator versetzt. Sie enthält im Allgemeinen 0,001 bis 10 Gew.-%, vorzugsweise 0,01 bis 5 Gew.-% und insbesondere 0,02 bis 2 Gew.-% Stabilisator, bezogen auf Hydroxylamin. Weder bei der Behandlung mit dem Anionenaustauscher noch bei der Behandlung mit dem Kationenaustauscher kommt es dann zu einer Verringerung der Stabilisatorkonzentration. Vielmehr wird die Stabilisatorkonzentration im Wesentlichen unverändert beibehalten. Dies ist von entscheidender Bedeutung, da die Stabilität und die Haltbarkeit der gereinigten Hydroxylaminlösung wesentlich durch den Gehalt an Stabilisator bestimmt wird. Nur bei Einhaltung enger Konzentrationsgrenzen für den stabilisator ist eine sichere Handhabung des Produkts gewährleistet.

Mit Hilfe des erfindungsgemäßen Verfahrens lassen sich sowohl Anionen als auch Kationen aus der Hydroxylaminlösung so weitgehend entfernen, dass die Hydroxylaminlösung "Electronic Grade"-Qualität besitzt.

Die nachfolgenden Beispiele erläutern die Erfindung, ohne sie zu begrenzen.

### Beispiele

### Als Stabilisator wurde in den Beispielen trans-1,2-Diaminocyclohexan-N,N,N',N'-tetraessigsäure verwendet

### Vergleichsbeispiel 1

50 gew.-%ige HA-Lösung mit einem Stabilisatorgehalt, der einem Gehalt an organischem Kohlenstoff von 250 µg/kg Lösung entspricht, und einem SO₄²⁻-Gehalt von 30 ppm wurde bei Raumtemperatur mit einer Belastung von 4,0 l/h über eine Laborionenaustauschersäule (Glas, L = 50 cm, D = 1,08 cm) gefördert. Die Höhe der Ionentauscherschüttung betrug 30 cm. Als Ionentauscher wurde der stark basische Anionentauscher Lewatit M511 eingesetzt. Der SO₄²-Gehalt der so behandelten Lösung betrug <10 ppm (Nachweisgrenze). Durch die Behandlung wurde jedoch auch der Stabilisator weitgehend abgetrennt. Der Gehalt der gereinigten Lösung betrug nur noch 40 µg organischem C/kg Lösung. Durch die Stabilisatorabtrennung ging die Stabilität der Lösung stark zurück. Die Stabilität der Lösung wird üblicherweise durch die Gasfreisetzung pro Zeit bei Lagerung der Lösung bei 100 °C ausgedrückt. Die über den Ionentauscher Lewatit M511 behandelte Lösung zeigte eine um den Faktor 5 erhöhte Gasfreisetzung, d.h. die derart behandelte Lösung ist nicht mehr ausreichend stabil.

### Vergleichsbeispiele 2 und 3:

Vergleichsbeispiel 1 wurde unter Verwendung des stark basischen Anionentauschers Amberlite IRA-900 (Vergleichsbeispiel 2) und unter Verwendung des schwach basischen Anionentauschers Amberlite IRA 92 (Vergleichsbeispiel 3) wiederholt. In beiden Fällen wurde der SO₄²⁻-Gehalt auf unter 10 ppm abgereichert. Allerdings nahm auch der Gehalt an Stabilisator auf <40 µg organischem C/kg Lösung ab.

### Beispiel 1:

Vergleichsbeispiel 1 wurde wiederholt. Allerdings wurde der Anionentauscher Lewatit M511 vor Versuchsbeginn vollständig durch Überleiten von Stabilisatorlösung (ca. 5 gew.-%ige Lösung von trans-1,2-Diaminocyclohexan-N,N,N',N'-tetraessigsäure in 50 gew.-%iger wässriger HA-Lösung) mit dem Stabilisator beladen. Über den derart vorbehandelten Anionentauscher wurde dann die HA-Lösung geleitet. Die SO₄²⁻-Ionen wurden dabei von ca. 30 ppm auf unter 10 ppm (Nachweisgrenze) abgetrennt. Die so gereinigte HA-Lösung enthielt nach der Behandlung einen Gehalt an organischem C von 280 µg/kg Lösung (Einsatzlösung: 250 µg/kg). Dies entspricht im Rahmen der Nachweisgrenze dem Wert der Einsatzlösung, d.h. durch das Vorbeladen des Anionentauschers blieb der Gehalt an Stabilisator in der Lösung während der Ionentauscherbehandlung unverändert.

Die bei diesem Versuch erhaltene SO₄²⁻-arme Lösung war so stabil wie die Einsatzlösung. Die Gasfreisetzung bei 100 °C war im Rahmen der Meßgenauigkeit identisch mit der Einsatzlösung.

## Patentansprüche

1. Verfahren zur Herstellung von hochreinen stabilisierten Hydroxylaminlösungen durch Behandlung einer wässrigen, Anionen enthaltenden stabilisierten Hydroxylaminausgangslösung mit einem Anionenaustauscher, **dadurch gekennzeichnet, dass** man einen mit einem Hydroxylamin-Stabilisator vorbeladenen Anionenaustauscher verwendet.

2. Verfahren nach Anspruch 1, **dadurch gekennzeichnet, dass** man als Stabilisator mindestens eine Verbindung der Formel
R¹R²N-A-NR³R⁴ (I)
worin
A für Alkylen, Alkenylen, Alkinylen, Cycloalkylen, Cycloalkenylen, Arylen, einen 5- oder 6-gliedrigen gesättigten oder ungesättigten Heterocyclus mit einem Stickstoffatom steht, wobei die genannten Reste 1, 2 oder 3 Substituenten aufweisen können, die unabhängig voneinander ausgewählt sind unter Alkyl, Alkoxy oder Hydroxy,
oder für 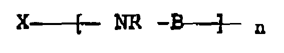 steht, worin
B und x für -CH₂CH₂- oder -CH₂CH₂CH₂- stehen,
n für 10 - 50 000 steht,
R für H, Alkyl, einen durch OH, NR₂, NHCOR⁵ oder COOH substituierten Ethylen- oder Propylenrest, CSSH, CO₂CN oder CH₂PO₃H₂ steht oder eine Brücke zu einem Stickstoffatom einer anderen Polyethylenimin- oder Polypropyleniminkette darstellt, wobei die Brücke durch 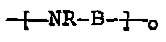 oder 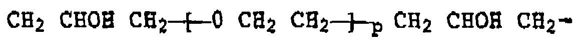 gebildet wird, wobei o und p unabhängig voneinander für 1 - 15 stehen,
R⁵ für H, C₁-C₁₈-Alkyl oder
CHR⁶COR⁶ steht, wobei R⁶ einen C₁₂-C₁₈-Alkylrest bedeutet,
R¹, R², R³ und R⁴ unabhängig voneinander für H, CH₂COOH, CH₂PO₃H₂, Alkyl, Acyl, CH₂CH₂OH, CH₂CH₂NH₂ oder 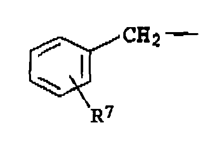 stehen, wobei
R⁷ für OH, SH, NH₂, CN, COOH, Alkyl oder Alkoxy steht,
oder die Salze davon enthalten, verwendet.

3. Verfahren nach Anspruch 1 oder 2, **dadurch gekennzeichnet, dass** man als Stabilisator wenigstens eine Verbindung verwendet, die ausgewählt ist unter cis- oder trans-1,2-Diaminocyclohexan-N,N,N',N'-tetraessigsäure, N,N'-Di(2-hydroxybenzyl)ethylendiamin-N,N'-diessigsäure, cis- oder trans-1,4-DiaminocyclO-C₅-C₆-alkyl-N,N,N',N'-tetraessigsäure, Diethylentriaminopentaessigsäure, Ethylenbis(oxyethylennitrilo)tetraessigsäure, Bis-hexamethylentriamin-pentaessigsäure; Hexamethylendiamin-tetraessigsäure; Tris(2-aminoethyl)amin-hexaessigsäure; Iminodiessigsäure und Polyethylenimin.

4. Verfahren nach einem der vorhergehenden Ansprüche, **dadurch gekennzeichnet, dass** man einen beladenen stark basischen Anionenaustauscher verwendet.

5. Verfahren nach einem der vorhergehenden Ansprüche, **dadurch gekennzeichnet, dass** man vor oder nach der Behandlung mit dem beladenen Anionenaustauscher eine Behandlung mit einem Kationenaustauscher vornimmt.

6. Verfahren zur Verringerung der Anionenkonzentrationen in wässrigen Hydroxylaminlösungen, wobei man eine wässrige Hydroxylaminlösung mit einem Anionenaustauscher behandelt, der mit einem Hydroxylamin-Stabilisator vorbeladen ist.

## Claims

1. A process for the preparation of high-purity, stabilized hydroxylamine solutions by treating an aqueous, anion-containing stabilized hydroxylamine starting solution with an anion exchanger, which comprises using an anion exchanger which has been pre-loaded with a hydroxylamine stabilizer.

2. The process according to claim 1 wherein the stabilizer used is at least one compound of the formula
R¹R²N-A-NR³R⁴ (I)
where
A is alkylene, alkenylene, alkynylene, cycloalkylene, cycloalkenylene, arylene, a 5- or 6-membered saturated or unsaturated heterocyclic ring containing a nitrogen atom, where said radicals may have 1, 2 or 3 substituents selected, independently of one another, from alkyl, alkoxy or hydroxyl, or is 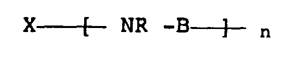
where
B and X are -CH₂CH₂- or -CH₂CH₂CH₂-,
n is 10-50,000,
R is H, alkyl, an ethylene or propylene radical which is substituted by OH, NH₂, NHCOR⁵ or COOH, CSSH, CH₂CN or CH₂PO₃H₂, or a bridge to a nitrogen atom of another polyethyleneimine or polypropyleneimine chain, where the bridge is formed by 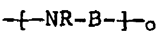 or 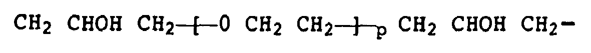 where o and p, independently of one another, are 1-15,
R⁵ is H, C₁-C₁₈-alkyl or CHR⁶COR⁶, where R⁶ is a C₁₂-C₁₈-alkyl radical,
R¹, R², R³ and R⁴, independently of one another, are H, CH₂COOH, CH₂PO₃H₂, alkyl, acyl, CH₂CH₂OH, CH₂CH₂NH₂ or 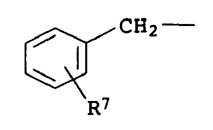
where
R⁷ is OH, SH, NH₂, CN, COOH, alkyl or alkoxy,
or the salts thereof.

3. The process according to claim 1 or 2 wherein the stabilizer used is at least one compound selected from the group consisting of cis- or trans-1,2-diaminocyclohexane-N,N,N',N'-tetraacetic acid; N,N'-di(2-hydroxybenzyl)ethylenediamine-N,N'-diacetic acid; diethylenetriaminopentaacetic acid; ethylenebis(oxyethylenenitrilo)tetraacetic acid, cis- or trans-1,4-diaminocyclo-C₅-C₆-alkyl-N,N,N',N'-tetraacetic acid; bishexamethylenetriaminepentaacetic acid; hexamethylenediaminetetraacetic acid; tris(2-aminoethyl)amine-hexaacetic acid; iminodiacetic acid and polyethyleneimine.

4. The process according to one of the preceding claims wherein a loaded, strongly basic anion exchanger is used.

5. The process according to one of the preceding claims wherein treatment with a cation exchanger is carried out before or after the treatment with the loaded anion exchanger.

6. A process for reducing the anion concentrations in aqueous hydroxylamine solutions, wherein an aqueous hydroxylamine solution is treated with an anion exchanger which has been pre-loaded with a hydroxylamine stabilizer.

## Revendications

1. Procédé de fabrication de solutions stabilisées d'hydroxylamine de grande pureté par traitement d'une solution aqueuse de départ stabilisée à base d'hydroxylamine contenant des anions avec un échangeur d'anions, **caractérisé en ce que** l'on utilise un échangeur anionique pré-chargé d'un stabilisateur d'hydroxylamine.

2. Procédé selon la revendication 1, **caractérisé en ce que** l'on utilise comme stabilisateur au moins un composé de formule suivante :
R¹R²N-A-NR³R⁴ (I)
dans laquelle :
A représente un groupement alkylène, alcénylène, alcynylène, cycloalkylène, cycloalcénylène, arylène, un hétérocycle saturé ou insaturé à 5 ou 6 éléments avec un atome d'azote, les radicaux cités pouvant présenter 1, 2 ou 3 substituants, qui sont choisis indépendamment l'un de l'autre parmi les groupements alkyle, alcoxy ou hydroxy,
ou représente : 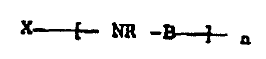 où :
B et X représentent -CH₂CH₂- ou -CH₂CH₂CH₂-,
n représente un nombre de 10 à 50.000,
R représente de l'hydrogène, un alkyle, un radical éthylène ou propylène substitué par un groupement OH, NH₂, NHCOR⁵ ou COOH; CSSH, CH₂CN ou CH₂PO₃H₂ ou représente un pont avec un atome d'azote d'une autre chaîne de polyéthylèneimine ou de poly-propylèneimine, le pont étant formé par 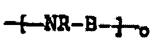 ou par 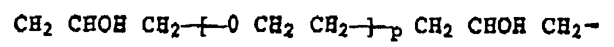 où o et p représentent indépendamment l'un de l'autre un nombre compris entre 1 et 15,
R⁵ représente de l'hydrogène, un alkyle en C₁-C₁₈ ou CHR⁶COR⁶, où R⁶ représente un alkyle en C₁₂₋C₁₈,
R¹, R², R³ et R⁴ représentent, indépendamment l'un de l'autre, de l'hydrogène, CH₂COOH, CH₂PO₃H₂, un alkyle, un acyle, CH₂CH₂OH, CH₂CH₂NH₂ ou le composé : 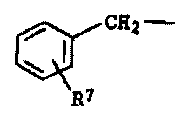
dans lequel :
R⁷ représente OH, SH, NH₂, CN, COOH, un alkyle ou un alcoxy, ou contiennent leurs sels.

3. Procédé selon la revendication 1 ou 2, **caractérisé en ce que** l'on utilise comme stabilisateur au moins un composé choisi parmi l'acide cis- ou trans-1,2-diaminocyclohexane-N,N,N',N'-tétraacétique, l'acide N,N'-di(2-hydroxybenzyl)éthylènediamine-N,N'-diacétique, l'acide cis- ou trans-1,4-diaminocyclo-alkyl(C₅₋C₆)-N,N,N',N'-tétraacétique, l'acide diéthylènetriaminopentaacétique, l'acide éthylènebis-(oxyéthylènenitrilo)tétraacétique, l'acide bis-hexaméthylènetriaminepentaacétique; l'acide hexaméthylènediaminetétraacétique; l'acide tris(2-aminoéthyl)aminehexaacétique; l'acide iminodiacétique et la polyéthylèneimine.

4. Procédé selon l'une quelconque des revendications précédentes, **caractérisé en ce que** l'on utilise un échangeur anionique chargé fortement basique.

5. Procédé selon l'une quelconque des revendications précédentes, **caractérisé en ce que** l'on effectue un traitement avec un échangeur cationique avant ou après le traitement avec l'échangeur anionique chargé.

6. Procédé pour diminuer la concentration d'anions dans des solutions aqueuses d'hydroxylamine, dans lequel on traite une solution aqueuse d'hydroxylamine avec un échangeur anionique qui est pré-chargé avec un stabilisateur d'hydroxylamine.
